# EUROPEAN PATENT SPECIFICATION

(11) **EP 0 365 244 B1**
(45) Date of publication and mention of the grant of the patent: **21.06.1995**
(21) Application number: 89310569.2
(22) Date of filing: 16.10.1989
(51) Int. Cl.: G02F 1/136, H01L 27/12

(54) **An active matrix substrate**
Substrat mit einer aktiven Matrix
Un substrat à matrice active

(30) Priority: 17.10.1988 JP 262347/88; 29.12.1988 JP 334125/88; 02.02.1989 JP 25469/89
(43) Date of publication of application: 25.04.1990
(73) Proprietor: SHARP KABUSHIKI KAISHA, Osaka 545 (JP)
(72) Inventor: Kanemori, Yuzuru, Tenri-shi Nara-ken (JP); Negoto, Hidenori, Ikoma-shi Nara-ken (JP); Katayama, Mikio, Ikoma-shi Nara-ken (JP); Inui, Motokazu, Kawachinagano-shi Osaka (JP); Yano, Kouzou, Yamatokoriyama-shi Nara-ken (JP); Tanaka, Hirohisa, Ikoma-gun Nara-ken (JP); Morimoto, Hiroshi, Kitakatsuragi-gun Nara-ken (JP)
(74) Representative: Jones, Colin

(56) References cited:
- EP-A- 0 166 225
- EP-A- 0 200 138
- EP-A- 0 234 994
- EP-A- 0 276 853
- PATENT ABSTRACTS OF JAPAN, vol. 8, no. 45 (P-257)[1482], 28th February 1984;& JP-A-58 196 522
- PATENT ABSTRACTS OF JAPAN, vol. 9, no. 246 (P-393)[1969], 3rd October 1985;& JP-A-60 97 322
- PATENT ABSTRACTS OF JAPAN, vol. 11, no. 195 (E-518), 23rd June 1987;& JP-A-62 022 455

## Description

The present invention relates to an active matrix substrate which contains switching devices such as thin film transistors (hereinafter abbreviated as "TFTs") which is used in combination with a display medium such as liquid crystal to construct a matrix display unit.

In recent years, active matrix substrates which comprise numerous pixel electrodes and switching devices arranged in a matrix form on insulating substrates have been employed in display units that use liquid crystals or the like.

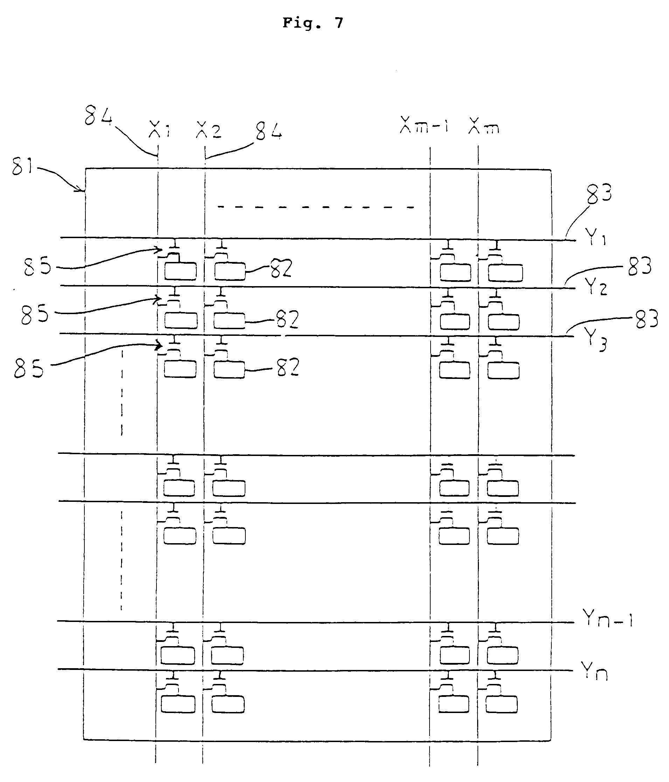

Fig. 7 shows a conventional active matrix substrate in a model form. TFTs **85** that function as switching devices are arranged in a matrix form on an insulating substrate **81** formed of glass or the like. The TFTs **85** are connected to gate bus lines **83** and also to source bus lines **84** disposed intersecting the gate bus lines **83**. The gate bus lines **83** function as scanning lines, the source bus lines **84** as signal lines. Connected to the TFTs **85** are pixel electrodes **82** formed, for example of, ITO (indium tin oxide). The TFTs **85** are switched on or off by electrical signals transmitted to the gate bus lines **83**. The driving of the pixel electrodes **82** is controlled by the on/off action of the TFTs **85**. To construct a display unit, a substance such as liquid crystal having light transmittance varying with the magnitude of an applied electrical field is sandwiched between the above-mentioned matrix substrate and a second insulating substrate which is also formed of glass or similar material. Voltage applied between the pixel electrodes **82** and counter electrodes disposed on the second insulating substrate and facing the pixel electrodes causes the light transmittance of the liquid crystal to change for the production of the display.

With the recent trend toward higher resolution of the display, pixel electrodes disposed on active matrix substrates are becoming even smaller in size and greater in number; in fact, a very large number of pixel electrodes are used to construct an active matrix substrate. With the increase in the number of pixel electrodes used, the number of failures resulting from broken bus lines, malfunctioning of TFTs, etc., has also been increasing. Such failures are serious problems as they result in pixel defects.

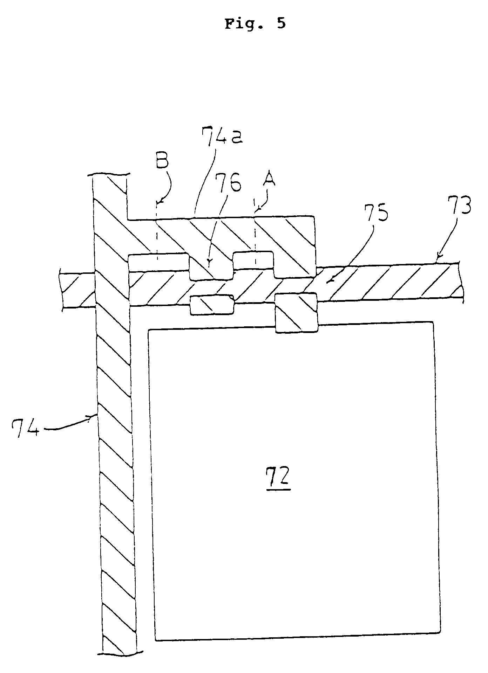

To solve such problems, an active matrix substrate has been developed having a construction allowing for defect correction (see Fig. 5). The active matrix substrate shown in Fig. 5 is provided with two TFTs **75** and **76** that are formed on a gate bus line **73**. The TFT **75** is electrically connected to a pixel electrode **72** via its drain electrode. The TFT **76** formed closer to a source bus line **74** serves as a spare TFT, and its drain electrode is not electrically connected to the pixel electrode **72**.

If any fault occurs to the TFT **75** connected to the pixel electrode **72**, a source bus branch line **74a** is cut off along a dotted line **A** using a laser beam or the like to electrically disconnect the TFT **75** from the source bus line **74**. Next, the drain electrode of the spare TFT **76** is electrically connected to the pixel electrode **72** by a photo-assisted CVD (photo-assisted chemical vapor deposition) technique using a laser beam. The pixel electrode **72** will thus be driven using the spare TFT **76**.

The above-mentioned defect correction method is effective only when the spare TFT **76** functions properly even if the TFT **75** originally connected to the pixel electrode **72** is defective. However, if the fault of the TFT **75** is attributable to entrapment of foreign matter, etc., due to improper resist coating, the parts adjacent to the defective TFT **75** are, in many cases, also defective, being affected by the same cause. Also, during the cutting process by the laser beam or during the connecting process by the photo-assisted CVD technique, the parts that do not need processing can be damaged or contaminated because of insufficient accuracy of the equipment used. This means that it is very likely that the spare TFT **76** will also become defective when the TFT **75** is defective. Therefore, with the active matrix substrate of Fig. 5, it has not been possible to sufficiently ensure defect correction in the case of the defective TFT **75** and other failures.

Furthermore, if the source bus branch line **74a** is broken, as shown by a dotted line **B** in Fig. 5, between the source bus line **74** and the TFT 76, both the TFTs **75** and **76** will become disconnected from the driving source, and therefore, the pixel electrode **72** will become unable to be driven.

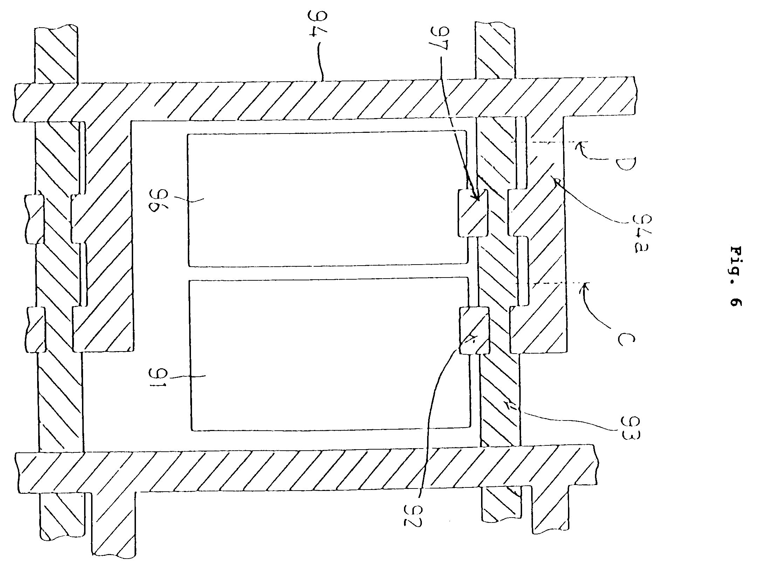

To solve the aforementioned problems such as TFT failure, another type of active matrix substrate as shown in Fig. 6 has also been proposed. This active matrix substrate comprises gate bus lines **93** and source bus lines **94** arranged in a grid-like form, and a pair of pixel electrodes **91** and **96** are disposed inside each of the regions surrounded by the gate bus lines **93** and source bus lines **94**, the pair of pixel electrodes **91** and **96** dividing the region into approximately two equal parts, for example, in the extending direction of the gate bus line **93**. The pixel electrodes **91** and **96**, respectively, are connected to the respective drain electrodes of two TFTs **92** and **97** disposed in a mutually parallel array on the gate bus line **93**. The TFTs **92** and **97** are positioned between a source bus branch line **94a** and one of the pixel electrodes **91** and **96**, respectively. The source bus branch line **94a** branches from the source bus line **94** and extends adjacent to and in parallel with the gate bus line **93**. The TFTs **92** and **97** are respectively connected to the tip and base portions of the source bus branch line **94a** via their source electrodes. The TFTs **92** and **97**, respectively, use portions of the gate bus line **93** disposed in parallel with the source bus branch line **94a** as their respective gate electrodes.

A data signal transmitted through the source bus line **94** and a scanning signal transmitted through the gate bus line **93** are input to drive the pair of TFTs **92** and **97** disposed in a mutually parallel array along the source bus branch line **94a**. Therefore, the data and scanning signals are input equally to the pair of TFTs **92** and **97**, and therefore, voltage is equally applied to the pair of pixel electrodes **91** and **96** in the region surrounded by the gate bus line **93** and the source bus line **94**. As a result, the paired pixel electrodes **91** and **96** function as if they are one pixel electrode, giving the active matrix substrate the display performance equal to that of the conventional active matrix substrate shown in Fig. 7 that has one pixel electrode in each one region surrounded by the bus lines.

Furthermore, if any one of the TFT **92** or **97**, respectively connected to the pixel electrodes **91** and **96**, is defective; or if the source bus branch line **94a** is broken, as shown by a dotted line C in Fig. 6, between the TFTs **92** and **97**, either of the TFT **92** that is not defective or the TFT **97** that is electrically connected to the source bus line **94** works to apply voltage to the pixel electrode **91** or **96** whichever connected to the properly functioning TFT. In the active matrix substrate shown in Fig. 7, any of such defectives has resulted in a defect affecting the pixel having the size approximately equal to that of each one region surrounded by the bus lines. On the other hand, in the active matrix substrate shown in Fig. 6, failure is only caused to the pixel having the size approximately half that of each one region surrounded by the bus lines. Since the pixel failure of the size approximately half that of each one region mentioned above is hardly discernible, the display performance of the active matrix substrate is markedly improved.

However, in the above active matrix substrate, if the source bus branch line **94a** extending from the source bus line **94** is broken, as shown by a dotted line D in Fig. 6, between the TFT **97** connected to the base portion thereof and the source bus line **94,** both the TFTs **92** and **97** connected to the source bus branch line **94a** will become disconnected from the driving source, resulting in pixel failure over an area approximately equal to the area of each region surrounded by the bus lines. If such a break is caused in the source bus branch line **94a**, the effect of disposing divided pixel electrodes in each region surrounded by the bus lines will become nullified.

In the above active matrix substrate, numerous gate bus lines are disposed intersecting numerous source bus lines in a mutually insulating manner. One bus line is disposed above the other bus line to intersect. The bus line positioned above the other at the intersecting point is usually susceptible to breakage. The breakage of such a bus line will appear as a streak on a display screen. Because such a streak greatly impairs the picture quality, development of an active matrix substrate allowing for correction of bus line breakage is hoped for.

Fig. 9 of EP-A-0276853 discloses an arrangement in which each cell element includes two display electrodes and four thin film transistors. In addition, an interconnection is provided between each pair of display electrodes.

Also disclosed herein is an active matrix substrate comprising pixel electrodes arranged in a matrix form on an insulating substrate, scanning lines disposed between the rows of the pixel electrodes arrayed in one direction, signal lines disposed intersecting said scanning lines, first switching devices each disposed adjacent to one side of each of said pixel electrodes, and second switching devices each disposed adjacent to a different side thereof from said side adjacent to which said first switching devices each are disposed, only the first switching devices out of the first and second switching devices being electrically connected each to the adjacent pixel electrode.

In one arrangement, either one of the first or the second switching devices is formed on the scanning line and is electrically connected to a branch line extending from the signal line and in parallel with said scanning line, while the other one is formed on a branch line extending from said scanning line and in parallel with said signal line and is electrically connected to said signal line.

In one arrangement, the first switch ing device is formed on the scanning line and is connected to a branch line which extends from the signal line and in parallel with said scanning line, while the second switching device is electrically connected both to said signal line and to one end of a branch line which extends from said scanning line and which is disposed in parallel with and beneath said signal line, the other end of said branch line from said scanning line extending sidewardly from beneath said signal line and being disposed adjacent to said scanning line in a mutually insulating manner.

The active matrix substrate of the present invention is as claimed in claim 1.

In a preferred embodiment, the respective ends of said spare line are disposed in close proximity to the respective sides of the intersecting portion of the scanning or signal line which intersects said line having a pair of branch lines and extends adjacent to and in parallel with the other line.

Thus, the invention described herein makes possible the objectives of (1) providing an active matrix substrate that ensures pixel defect correction if pixel defect occurs because of a defective switching device or a broken bus branch line; (2) providing an active matrix substrate that minimizes the area of pixel defect if pixel defect occurs because of a defective switching device or a broken bus branch line; and (3) providing an active matrix substrate allowing for correction of a broken bus line if the bus line is broken at its intersecting portion.

By way of example only, a specific embodiment of the present invention will now be described, with reference to the accompanying drawings, in which:-

Fig. 1 is a plan view showing the main part of an active matrix substrate, but which does not form part of the present invention.

Fig. 2 is a plan view showing the main part of another active matrix substrate, but which does not form part of the present invention.

Fig. 3 is a plan view showing the main part of an active matrix substrate of the present invention.

Fig. 4a is a diagram showing a defect correction process by which a defect that has occurred on the active matrix substrate of Fig. 3.

Figs. 4b and 4c, respectively, are diagrams showing other defect correction processes by which defects that have occurred on the active matrix substrate of Fig. 3.

Fig. 5 is a diagram showing a defect correction process by which a defect that has occurred on a conventional active matrix substrate.

Fig. 6 is a diagram showing another defect correction process by which a defect that has occurred on a conventional active matrix substrate.

Fig. 7 is a schematic diagram showing a conventional active matrix substrate.

### Example 1

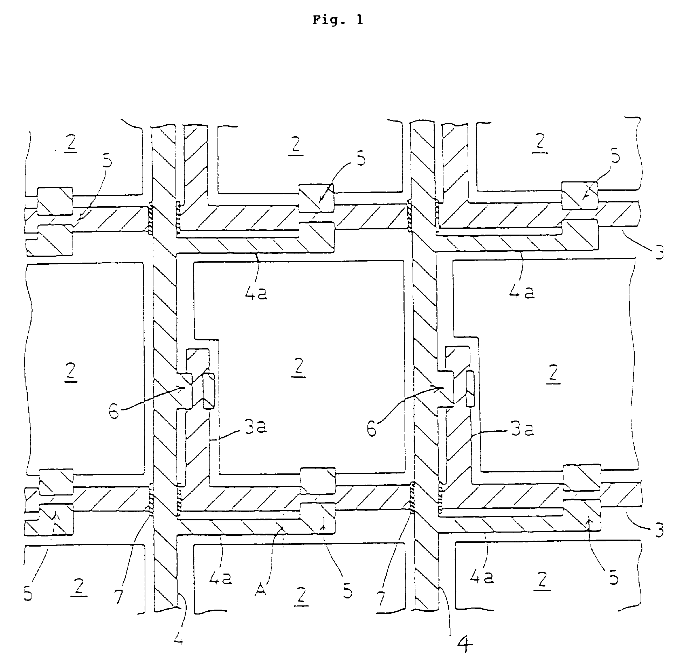

Fig. 1 is a plan view showing the main part of one arrangement not forming part of the present invention. There are pixel electrodes 2 disposed in a matrix form on a glass substrate. Disposed between the rows of the pixel electrodes **2** arrayed in the horizontal direction in Fig. 1 are gate bus lines **3.** On the other hand, source bus lines **4** are disposed between the rows of the pixel electrodes **2** arrayed in the vertical direction. In this embodiment, TFTs **5** are disposed on the gate bus lines **3,** while spare TFTs **6** are disposed on gate bus branch lines **3a** extending in parallel with the source bus lines **4**. The source electrode of each of the TFTs **5** is electrically connected to a source bus branch line **4a** extending in parallel with the adjacent gate bus line **3,** while the drain electrode thereof is electrically connected to the corresponding pixel electrode **2.** In this embodiment, the pixel electrode **2** is driven by the TFT **5** when the TFT **5** properly functions. The source electrode of the corresponding spare TFT **6** is electrically connected to the source bus line **4**, but its drain electrode is not electrically connected to the pixel electrode **2**. However, the drain electrode of the TFT **6** is disposed in close proximity to the pixel electrode **2**. Therefore, the drain electrode of the TFT **6** can be easily connected to the pixel electrode **2** electrically, using a photo-assisted CVD and other technique.

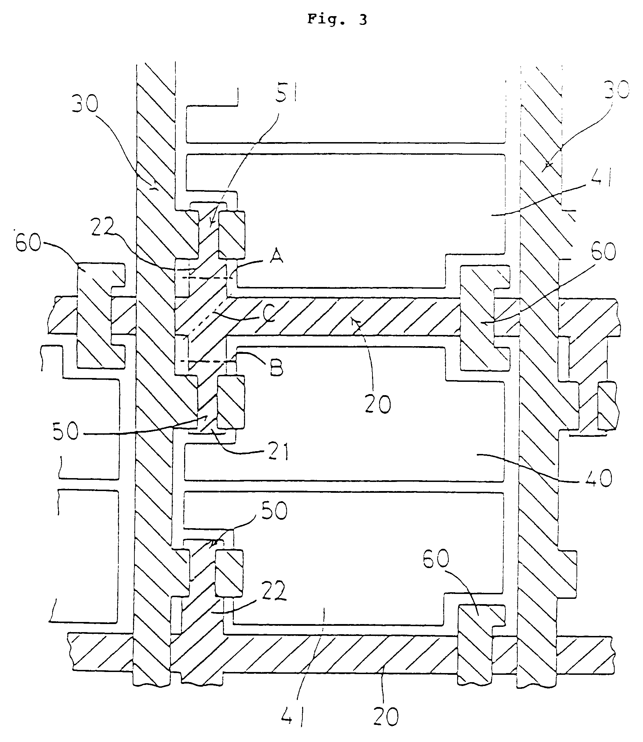

As described above, the TFT **6** and the TFT **5** are respectively disposed in close proximity to different sides of the same pixel electrode **2**, providing sufficient space between the TFT **6** and the TFT **5**. This arrangement reduces the possibility of the spare TFT **6** becoming defective because of the same cause when the TFT **5** is defective. It is therefore apparent that the above arrangement provides surer defect correction in the case of TFT **5** failure than the arrangement in which two TFTs **50** and **51** are disposed close to each other such as those shown in Fig. 3.

Next, is the description dealing with the outline of the method for the manufacture of the active matrix substrate of this arrangement. Gate bus lines 3 are formed on a glass substrate using, for example, tantalum. In addition to the main lines, gate bus branch lines **3a** are also formed on which spare TFTs **6** are to be formed. Next, a gate insulating film and a semiconductor layer are deposited on the gate bus lines **3** and their branch lines **3a**, which are then subjected to a patterning process to form the channels of TFTs **5** and **6**. The gate insulating film is formed, for example, of silicon nitride (hereinafter referred to as "SiNx"), and the semiconductor layer is formed, for example, of intrinsic amorphous silicon (hereinafter referred to as "a-Si(i)"). After that, source bus lines **4** (including the source electrodes of the TFTs **6**), source bus branch lines **4a** (including the source electrodes of the TFTs **5**), and the drain electrodes of the TFTs **5** and **6** are formed, for example, of titanium. Also, pixel electrodes **2** are formed, for example, of ITO. Furthermore, insulating materials **7** such as silicon nitride are deposited between the source bus lines **4** and the gate bus lines **3** where they intersect each other to prevent leakage between the adjacent source bus and gate bus lines.

The following describes how the defect correction is carried out. When the TFT **5** is defective in its characteristics and is unable to properly drive the pixel electrode **2**, a laser beam with an adjusted beam diameter is projected to cut off the source bus branch line **4a** along the dotted line **A**, disconnecting the electrical connection between the defective TFT **5** and the source bus line **4**. Next, the glass substrate is placed in an atmosphere of a gas containing a suitable metallic element (e.g., W(CO)₆ containing tungsten), and a laser beam of a suitable kind is projected to the space between the spare TFT **6** and the pixel electrode **2** to deposit the metal at the point where the laser beam is projected by making use of the photo-assisted CVD phenomenon. The spare TFT **6** is thus electrically connected to the pixel electrode **2**, which enables the pixel electrode **2** to be driven by the spare TFT **6**.

In the case of a break caused in the source bus branch line **4a** to which the source electrode of the TFT **5** is connected, the spare TFT **6** is electrically connected to the pixel electrode **2** using the laser beam in the same manner as mentioned above to correct the defect.

Virtually the same effect as the above example can be obtained if the reverse construction to that of the above example is employed, i.e., the drain electrode of the TFT **6** is electrically connected to the pixel electrode **2** while the drain electrode of the TFT **5** is not electrically connected to the pixel electrode **2**.

In the above arrangement, the two switching devices are respectively disposed in close proximity to different sides of the same pixel electrode, providing sufficient space between them as compared with the case in which the switching devices are disposed in close proximity to the same side of the pixel electrode. Therefore, if the switching device originally connected electrically to the pixel electrode becomes defective for any reason, there is little possibility that the other switching device not electrically connected to the pixel electrode will also become defective. Furthermore, the above arrangement reduces the possibility of damaging the other switching device when disconnecting the defective switching device.

In the construction of the above example, one of the two switching devices is formed on the scanning line and is electrically connected to the signal branch line disposed parallel to the scanning line, while the other switching device is formed on the scanning branch line disposed parallel to the signal line and is electrically connected to the signal line. With this arrangement, if a defect is caused due to breakage of one of the two branch lines, there will be no simultaneous disconnection of both the switching devices from the signal line, and it is therefore possible to correct the defect.

On the above active matrix substrate, there are disposed pixel electrode areas through which light is transmitted and pixel electrode areas through which no light is transmitted. The ratio of the light transmitting areas to the entire area of the active matrix substrate is known as the aperture ratio. If the aperture ratio decreases, the display screen will darken and therefore, is not desirable. Because of the provision of the gate bus branch lines **3a** for connection between the gate electrodes of the spare TFTs **6** and the gate bus lines **3**, the active matrix substrate of this embodiment has a smaller aperture ratio than the active matrix substrate not provided with spare TFTs **6**, and therefore has a disadvantage of a darker display screen.

### Example 2

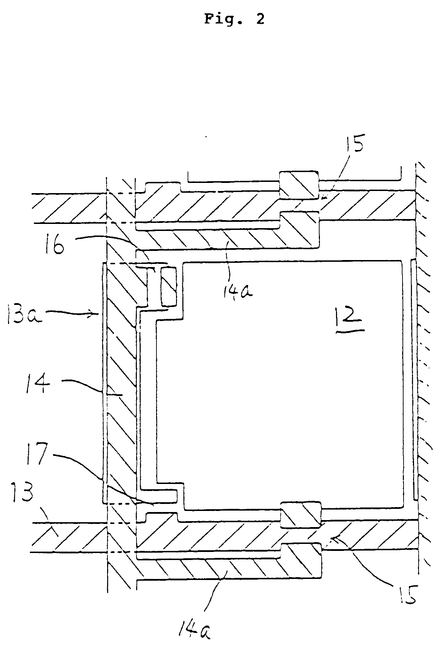

Fig. 2 is a plan view showing the main part of another arrangement which is not part of the present invention wherein the aperture ratio does not drop, despite the provision of spare TFTs. There are pixel electrodes **12** disposed in a matrix form on a glass substrate, each of the pixel electrodes **12** being provided with a TFT **15** for driving the pixel electrode **12**. A gate bus line **13** is provided extending beneath the drain and source electrodes of the TFT **15** connected to the pixel electrode **12**, a portion of the gate bus line **13** serving as the gate electrode of the TFT **15**. The source electrode of the TFT **15** is connected to a source bus branch line **14a** branching from the source bus line **14** that intersects the gate bus line **13** and extending parallel to the gate bus line **13**.

Also, in this arrangement, a spare TFT 16 is provided to each of the pixel electrodes **12**. The drain electrode of the spare TFT **16** is not connected to the pixel electrode **12** but disposed in close proximity thereto for facilitation of later connection by means of a photo-assisted CVD or other technique. The source electrode of the spare TFT **16** is connected to the source bus line **14**, the gate electrode thereof being provided beneath the drain and source electrodes. In this embodiment, a gate bus branch line **13a** extending from the gate electrode of the spare TFT **16** toward the gate bus line **13** is disposed beneath the source bus line **14** with an insulating film interposed therebetween. The gate bus branch line **13a** extends parallel to the source bus line **14** superposed thereon toward the gate bus line **13**. With this arrangement, it is possible to provide the gate bus branch line **13a** without reducing the area of the pixel electrode **12.**

The end portion of the gate bus branch line **13a** extends sidewardly from beneath the source bus line **14** toward a connection point **17** with the gate bus line **13**, the end portion being not connected to the gate bus line **13** but positioned in close proximity to a protrusion formed on the gate bus line **13** for later connection thereto by means of a laser-assisted CVD, etc.

In this arrangement, the pixel electrode 12 is formed, for example, of ITO. The gate bus line **13**, the gate bus branch line **13a**, and the gate electrode of the TFT **15** are formed, for example, of tantalum. The source bus line **14**, the source bus branch line **14a**, and the source electrodes of the TFTs **15** and **16** are formed, for example, of titanium. The insulating film interposed between the gate bus branch line **13a** and the source bus line **14** is formed, for example, of SiNx, a-Si(i), etc., the insulating film not being disposed on the connection point **17** so as to provide electrical connection at the time of later defect correction. Also, an insulating material such as SiNx, a-Si(i), a-Si(n⁺), etc., is interposed between the gate bus line **13** and the source bus line **14** where they intersect each other to prevent leakage between these adjacent lines.

In the active matrix substrate of this arrangement, when the TFT 15 is defective, the pixel is recovered from the defect in the following manner. First, the source bus branch line **14a** extending from the source bus line **14** is cut off by means of a laser beam to disconnect the electrical connection between the defective TFT **15** and the source bus line **14**. Then, using a laser beam-assisted CVD or other technique, electrical connections are provided between the drain electrode of the spare TFT **16** and the pixel electrode **12** and between the gate bus line **13** and the gate bus branch line **13a** at the connection point **17**. Thus, the defective TFT **15** is disconnected, and the spare TFT **16** is put into use to drive the pixel electrode **12**. Furthermore, in this embodiment, defect correction is performed in the same manner as above in the case of a defect caused by breakage of the source bus branch line **14a**.

In this arrangement, as described above, the scanning branch line to which the spare switching device adjacent to the pixel electrode is connected is disposed beneath the signal line, the scanning branch line and the scanning line being positioned in close proximity to each other for facilitation of later connection. Thus, the pixel defect correction function is provided with ease and without decreasing the aperture ratio.

### Example 3

Fig. 3 shows an embodiment of the active matrix substrate of the present invention, wherein a plurality of gate bus lines **20** parallel to each other and formed, for example, of tantalum, are disposed with a suitable space provided between each other on a light transmission insulating substrate. Also on the insulating substrate, parallel source bus lines **30** formed, for example, of titanium, are arranged with a suitable space provided between each other. Material such as SiNx is interposed between the gate bus lines **20** and the source bus lines **30** where they intersect each other to provide insulation between the two adjacent lines and thereby prevent electrical leakage.

In each pixel region on the insulating substrate surrounded by a pair of facing gate bus lines **20** and a pair of facing source bus lines **30**, a pair of pixel electrodes **40** and **41** are disposed, for example, one on top of the other in the extending direction of the source bus lines **30**. The pixel electrodes **40** and **41** are formed, for example, of ITO, and have cut-off corners that correspond to the corners of the pixel region surrounded by the bus lines **20** and **30**.

Each gate bus line **20** disposed between a pair of pixel regions adjacent to each other in the extending direction of the source bus lines **30** is provided with a pair of gate bus branch lines **21** and **22** respectively extending into the adjacent pixel regions. The gate bus branch lines **21** and **22** extend adjacent to, and in parallel with, one of the facing source bus lines **30** that define the pixel regions into which the respective branch lines **21** and **22** extend, the branch lines **21** and **22** extending into the cut-off portions of the pixel electrodes **40** and **41**. TFTs **50** and **51** are disposed on the gate bus branch lines **21** and **22**, the TFTs **50** and **51** being electrically connected to the source bus line **30** as well as to the pixel electrodes **40** and **41**, respectively. The TFTs **50** and **51** are electrically connected to the source bus line **30** via their source electrodes, while their gate electrodes are electrically connected to the gate bus line **20** through the respective gate bus branch lines **21** and **22**. Also, the drain electrodes of the TFTs **50** and **51** are electrically connected to the pixel electrodes **40** and **41**, respectively.

A scanning signal is input to each gate bus line **20**, a data signal to each source bus line **30**. The TFTs **50** and **51** to which both signals are input are driven to apply voltage to the pixel electrodes **40** and **41** connected to the TFTs **50** and **51**, respectively.

Disposed above the gate bus line **20** formed between the pair of adjacent pixel regions is a spare line **60** formed, for example, of titanium. The spare line **60** is positioned at a portion of the gate bus line **20** opposite to the portion thereof where the gate bus branch lines **21** and **22** are positioned. The spare line **60** spans the gate bus line **20** so that its respective ends extend into the adjacent pixel regions. Between the spare line **60** and the gate bus line **20**, an insulating film is inserted for electrical insulation between them. Each extreme end of the spare line **60** projects toward the adjacent source bus line **30**, but not in contact therewith.

The active matrix substrate of the above construction is manufactured in the following manner. first, gate bus lines **20** are formed on an insulating substrate using tantalum. Then, layers of SiNx and a-Si(i) are successively formed, and then subjected to a patterning process to form TFTs **50** and **51** using a known method. At the time of the patterning, the SiNx film is left unremoved from the portions between the gate bus lines **20** and the source bus lines **30** where they intersect each other to prevent electrical leakage. Thereafter, the source bus lines **30** and spare lines **60** are formed using titanium, and then, pixel electrodes **40** and **41** are formed using ITO to complete the construction of the active matrix substrate of this embodiment.

In the above active matrix substrate, the scanning signal is input to the gate bus line **20**, the data signal to the source bus line **30**. The TFTs **50** and **51** to which both signals are input are driven to apply voltage to the pixel electrodes **40** and **41** connected to the TFTs **50** and **51**, respectively. The scanning signal fed to the gate bus line **20** formed between the pair of pixel regions adjacent to each other in the extending directions of the facing source bus lines **30** is input to the pair of gate bus branch lines **21** and **22** that extend from the gate bus line **20** into the respective pixel regions. Since the TFTs **50** and **51** connected to the respective gate bus lines **21** and **22** are connected to the same source bus line **30**, the TFTs **50** and **51** are driven by the same scanning and data signals.

In the above active matrix substrate, if one of the TFT **50** or **51**, respectively connected to the pair of pixel electrodes **40** and **41** adjacent to each other across the gate bus line **20**, fails to be driven by the given driving signals because of the breakage at the base of either of the gate bus branch line **21** or **22** as shown by a dotted line **A** or **B** in Fig. 3, the other TFT will be driven by the given driving signals. This means that a break caused in one of the gate bus line **21** or **22** does not result in the simultaneous disconnection from the driving source of both of the pixel electrodes **40** and **41** facing each other across the gate bus line **20**. The same is also true of the case in which failure is caused to either one of the TFTs **50** and **51** opposite each other across the gate bus line **20**.

Also, it is possible that the gate bus line **20** itself is broken, for example, as shown by a dotted line **C** in Fig. 3. In this case, the gate bus line **20** is split into two parts separated by the dotted line **C**, and all the TFTs **50** and **51** disposed in pairs across the gate bus line **20** in the part where no scanning signal is input will be disconnected from the driving source. However, in a usual manufacturing process of active matrix substrates, since the gate bus lines **20** are formed on the insulating substrate in the first patterning process, wiring defects such as breaks in lines are checked immediately after the patterning. Therefore, the aforementioned breakage of the gate bus line **20** can be easily checked out, and there is little possibility of manufacturing active matrix substrates with broken gate bus lines **20**.

The pixel defect area caused such as mentioned above is approximately equal to half the area of the pixel region surrounded by the gate bus line **20** and source bus line **30**. The pixel defect of this degree is tolerable in a conventional television receiver or the like. However, in display units requiring high resolution performance, it becomes necessary to correct the defect on the active matrix substrate.

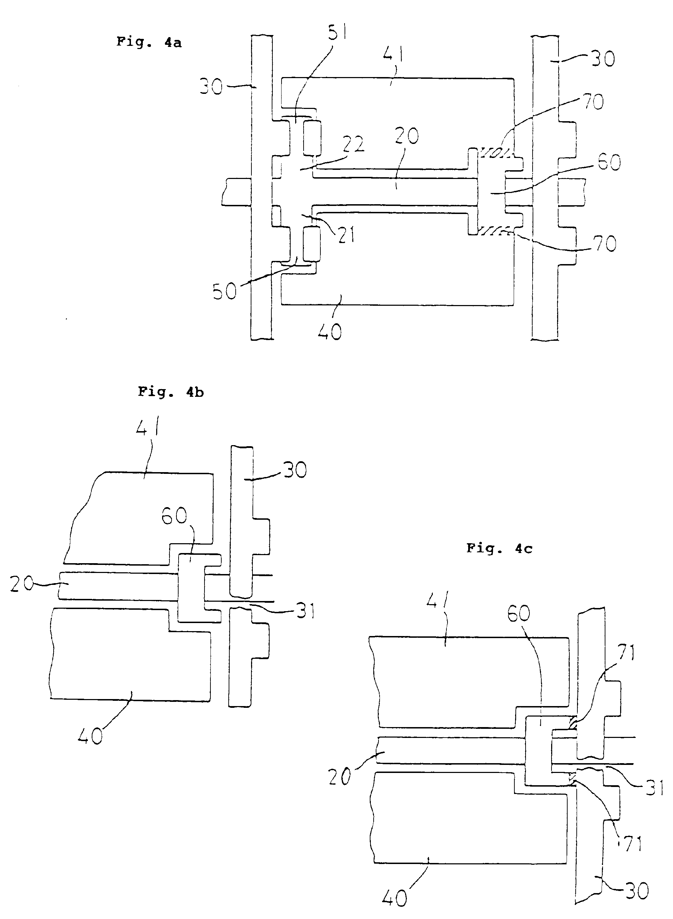

In the active matrix substrate of this embodiment, defect correction proceeds in the following way. If, for example, either one of the TFTs **50** and **51** connected to the same gate bus line **20** becomes defective and therefore unable to be driven, the pixel electrode connected to the defective TFT **50** or **51** will not function. Then, as shown by the oblique lines **70** and **70** in Fig. 4a, the ends of the spare line **60** disposed spanning the gate bus line **20** are electrically connected by means of the photo-assisted CVD technique to the pixel electrodes **40** and **41** in the pixel regions in which the respective ends are positioned. Since the spare line **60** is insulated from the gate bus line **20**, the pixel electrodes **40** and **41** adjacent to each other across the gate bus line **20** become electrically connected to each other for simultaneous operation. The pixel electrode connected to the defective TFT **50** or **51** is thus driven through the other pixel electrode and the spare line **60** by the other TFT that functions properly. Each of the TFTs **50** and **51** connected to the pixel electrodes **40** and **41**, respectively, has the capability of driving the pair of pixel electrodes **40** and **41** after completion of the defect correction.

Also in this embodiment, in the case of a broken source bus line **30**, the broken line can be easily corrected using the spare line **60**. Usually, most of the breakage of the source bus line **30** is caused to the stepped portion thereof where it intersects the gate bus line **20**. As shown in Fig. 4b, when a break **31** is caused in the source bus line **30** at its stepped portion above the gate bus line **20**, as shown by slash marks **71** of Fig. 4c, the portions at both ends of the spare line **60** that protrude toward the source bus line **30** are connected by means of the photo-assisted CVD technique to the respective portions of the source bus line **30** that face the protruding portions. Thus, the spare line **60** is made to span the break **31** to provide electrical connection between the separated portions of the source bus line **30**, thus correcting the defect caused by the break of the source bus line **30**.

This embodiment shows the arrangement in which the pixel electrodes **40** and **41** adjacent to each other across the gate bus line **20** are connected to the gate bus line **20**, but it is also possible to employ the arrangement in which a pair of pixel electrodes adjacent to each other across the source bus line **30** are connected to the source bus line **30**.

As described above, in this embodiment, a plurality of pixel electrodes are disposed in each of the regions surrounded by the bus lines arranged in a grid-like form, each of the paired pixel electrodes disposed facing each other across the specified bus line being electrically connected to the bus line via a switching device. With this arrangement, if one of the paired pixel electrodes fails, the defect pixel area affected can be reduced to a minimum.

In this embodiment, a spare line is provided which intersects in an insulated manner with the bus line between the paired pixel electrodes, the ends of the spare line being disposed in close proximity to the respective pixel electrodes. If the switching device connected to one of the paired pixel electrodes, or if the bus line connected to the switching device is broken, the spare line will then be used to provide electrical connection between the paired pixel electrodes. With this connection, the paired pixel electrodes are driven by the other switching device that properly functions.

Furthermore, in this embodiment, the ends of the spare line are positioned in close proximity to the side portions of the bus line across the portion thereof that intersects the bus line disposed between the paired pixel electrodes. If a break is caused in this intersecting portion, the ends of the spare line will then be connected to the side portions of the bus line spanning the broken point. The broken bus line can be corrected with this connection.

In any of the above embodiments, TFTs are used as the switching devices, but instead of TFTs, MIM (metal-insulator-metal) devices, MOS transistors, diodes, varistors, etc., can be, of course, used.

## Claims

1. An active matrix substrate comprising scanning lines (20) and signal lines (30) which are both disposed on an insulating substrate and arrayed in horizontal and vertical directions, respectively, a plurality of pixel electrodes (40,41), and a plurality of switching devices (50,51) electrically connected to said pixel electrodes within each region surrounded by the scanning and signal lines, wherein the pixel electrodes (40,41) are disposed in a pair adjacent to each other across either the scanning (20) or the signal (30) line, said scanning or signal line having a pair of branch lines, and are electrically connected via their respective switching devices (50,51) disposed on the pair of branch lines to the scanning (20) and the signal (30) lines, characterised in that each said region contains two pixel electrodes, and in that
a spare line (60) is provided which intersects said line having the pair of branch lines in a mutually insulating manner, the ends of the spare line being respectively disposed in close proximity but unconnected to said pixel electrodes (40,41) disposed in a pair adjacent to each other across said line having the pair of branch lines,
said spare lines being connectable to the respective pixel electrodes such that upon failure of a switching device both pixel electrodes are drivable by the other switching device.

2. An active matrix substrate according to claim 1, wherein the respective ends of said spare line (60) are disposed in close proximity to the respective sides of the intersecting portion of the scanning (20) or signal (30) line which intersects said line having the pair of branch lines and extends adjacent to and in parallel with the other line.

## Patentansprüche

1. Aktivmatrixsubstrat mit Abrasterleitungen (20) und Signalleitungen (30), die beide auf einem isolierenden Substrat angeordnet sind und in horizontaler bzw. vertikaler Richtung ausgerichtet sind, mehreren Pixelelektroden (40, 41) und mehreren Schaltbauteilen (50, 51), die elektrisch innerhalb des von den Abraster- und Signalleitungen umgebenen Bereichs mit den Pixelelektroden verbunden sind, wobei die Pixelelektroden (40, 41) paarweise so angeordnet sind, daß sie entweder über eine Abrasterleitung (20) oder eine Signalleitung (30) hinweg einander benachbart sind, wobei die Abraster- oder Signalleitung ein Paar Zweigleitungen aufweist und sie elektrisch über ihre jeweiligen Schaltbauteile (50, 51), die auf dem Paar Zweigleitungen angeordnet sind, mit den Abrasterleitungen (20) und den Signalleitungen (30) verbunden sind, **dadurch gekennzeichnet**, daß dieser Bereich zwei Pixelelektroden enthält, und daß eine Ersatzleitung (60) vorhanden ist, die die Leitung mit dem Paar Zweigleitungen in gegeneinander isolierter Weise schneidet, wobei die Enden der Ersatzleitung jeweils nahe an den Pixelelektroden (40, 41), die paarweise so angeordnet sind, daß sie über die Leitung mit dem Paar Zweigleitungen hinweg einander benachbart sind, angeordnet sind, jedoch nicht mit diesen verbunden sind, wobei die Ersatzleitungen so mit den jeweiligen Pixelelektroden verbindbar sind, daß beim Ausfall eines Schaltbauteils beide Pixelelektroden vom anderen Schaltbauteil betrieben werden können.

2. Aktivmatrixsubstrat nach Anspruch 1, bei dem die jeweiligen Enden der Ersatzleitung (60) nahe bei den jeweiligen Seiten des Überschneidungsabschnitts der Abrasterleitung (20) oder der Signalleitung (30), die die Leitung mit dem Paar Zweigleitungen überschneidet und sich parallel zur anderen Leitung benachbart zu dieser erstreckt, angeordnet sind.

## Revendications

1. Substrat à matrice active, comprenant des lignes d'exploration (20) et des lignes de transmission de signaux (30), qui toutes les deux sont disposées sur un substrat isolant et sont arrangées respectivement dans la direction horizontale et dans la direction verticale, une pluralité d'électrodes de pixels (40, 41), et une pluralité de dispositifs de commutation (50, 51) électriquement connectés auxdites électrodes de pixels dans chaque région entourée par les lignes d'exploration et les lignes de transmission de signaux, où les électrodes de pixels (40, 41) sont disposées sous forme d'une paire, en étant adjacentes l'une de l'autre en travers de la ligne d'exploration (20) ou de la ligne de transmission de signaux (30), ladite ligne d'exploration ou de transmission de signaux ayant une paire de dérivations, et sont électriquement connectées, par l'intermédiaire de leurs dispositifs de commutation respectifs (50, 51), disposés sur la paire de dérivations, aux lignes d'exploration (20) et aux lignes de transmission de signaux (30), caractérisé en ce que chacune desdites régions contient deux électrodes de pixels, et qu'on prévoit une ligne de secours (60), qui coupe la ligne comportant la paire de dérivations en assurant une isolation réciproque, les extrémités de la ligne de secours étant disposées respectivement au voisinage immédiat, mais sans connexion, desdites électrodes de pixels (40, 41) disposées en une paire, adjacentes l'une à l'autre, à travers ladite ligne comportant la paire de dérivations, lesdites lignes de secours pouvant être connectées aux différentes électrodes de pixels de façon que, après défaillance d'un dispositif de commutation, les deux électrodes de pixels puissent être excitées par l'autre dispositif de commutation.

2. Substrat à matrice active selon la revendication 1, dans lequel les extrémités respectives de la ligne de secours (60) sont disposées au voisinage immédiat des côtés respectifs de la partie en intersection de la ligne d'exploration (20) ou de la ligne de transmission de signaux (30), qui coupe ladite ligne ayant la paire de dérivations et s'étend au voisinage immédiat de l'autre ligne, parallèlement à cette dernière.
